(19) Europäisches Patentamt

European Patent Office

Office européen des brevets

(11) EP 2 500 835 A1

(12) **EUROPEAN PATENT APPLICATION**

(43) Date of publication:
19.09.2012 Bulletin 2012/38

(51) Int Cl.:
$G06F\ 17/40^{(2006.01)}$   $H03M\ 7/30^{(2006.01)}$

(21) Application number: 12156157.5

(22) Date of filing: 20.02.2012

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 18.03.2011 JP 2011060597

(71) Applicant: NEC Corporation
Tokyo 108-8001 (JP)

(72) Inventor: Nyuunoya, Yoshinori
Tokyo 108-8001 (JP)

(74) Representative: Vossius & Partner
Siebertstrasse 4
81675 München (DE)

(54) **Data storage apparatus and data storage method**

(57)    A data storage apparatus of the present invention includes a data collector that collects time-series data and a sampler that calculates, for each piece of the data, a plurality of change indices indicating change in each piece of the data and determines whether or not the piece of data is to be sampled.

Fig.1

**Description**

This application is based upon and claims the benefit of priority from Japanese patent application No. 2011-060597, filed on March 18, 2011, the disclosure of which is incorporated herein in its entirety by reference.

The present invention relates to a data storage apparatus and a data storage method.

With the advent of massive data centers and cloud computing, computer systems continue to grow in size.

As computer systems grow in size, the amount of resource data indicating usage of resources of the computer systems (such as memory usage, the number of open files, and the number of threads generated) is also increasing.

Consequently, the capacities of storage media is infrequently used to store resource data regarding tasks that are not directly related to the primary tasks that is to be performed on computer systems.

Therefore, when time-series data which varies constantly is stored, the time-series data is sampled to decimate the time-series data in order to reduce the number of pieces of time-series data to be stored.

An approach to sampling time-series data at regular intervals is used generally. However, there is a problem that the amount of time-series data and the accuracy of the time-series data (the difference between the time-series data and original observational data) are dependent on the sampling interval.

To solve the problem, JP10-143543A proposes an approach in which the amount of change between the current and previous time-series data is calculated as an index of change in the current time-series data and the current time-series data is sampled on the basis of the calculated amount of change.

However, the sampling accuracy of the approach proposed in JP10-143543A is low because the approach uses only one index, the amount of change, as the index of change in the time-series data. Therefore, the approach has the problem that the number of pieces of data to be sampled cannot satisfactorily be reduced.

Specifically, time-series data that changes linearly can be reproduced by sampling only data at the start point of a change and data at the end point of the change, for example.

However, if only the amount of change is used as the index of change as in JP10-1435543A, there is the potential of sampling the data in the entire period during which the data is linearly changing, depending on the gradient of the time-series data.

Summary of the Invention

Therefore, an object of the present invention is to solve the problems described above and provide a data storage apparatus and a data storage method capable of satisfactorily reducing the number of pieces of data sampled while improving the accuracy of sampling.

A data storage apparatus of the present invention includes a data collector that collects time-series data, and a sampler that calculates a plurality of change indices indicating a change in each piece of the data and determines, on the basis of the result of the calculation, whether or not the piece of the data is to be sampled.

A data storage method of the present invention is a method of storing data by a data storage apparatus. The method includes a collecting step of collecting time-series data, and a sampling step of calculating a plurality of change indices indicating a change in each piece of the data and determining, on the basis of the result of the calculation, whether or not the piece of the data is to be sampled.

The present invention has the advantageous effect of satisfactorily reducing the quantity of data sampled while improving the accuracy of sampling.

The above and other objects, features, and advantages of the present invention will become apparent from the following description with reference to the accompanying drawings which illustrate examples of the present invention.

FIG. 1 is a block diagram illustrating a configuration of a data storage apparatus according to an exemplary embodiment of the present invention;

FIG. 2 is a flowchart illustrating a data storing operation of the data storage apparatus illustrated in FIG. 1;

FIG. 3 is a flowchart illustrating a dynamic sampling procedure at step A2 of FIG. 2;

FIG. 4 is a diagram illustrating an example of resource data stored in the data storage apparatus illustrated in FIG. 1;

FIG. 5 is a diagram illustrating another example of resource data stored in the data storage apparatus illustrated in FIG. 1;

FIG. 6 is a flowchart illustrating a data merge procedure at step A6 of FIG. 2; and

FIG. 7 is a diagram illustrating a data restore operation of the data storage apparatus illustrated in FIG. 1

Exemplary embodiments for carrying out the present invention will be described below with reference to drawings.

The exemplary embodiments will be described by taking an example in which resource data representing usage of resources of a computer system, such as memory usage, the number of open files, and the number of threads generated, is stored as time-series data.

(1) Configuration of an Exemplary Embodiment

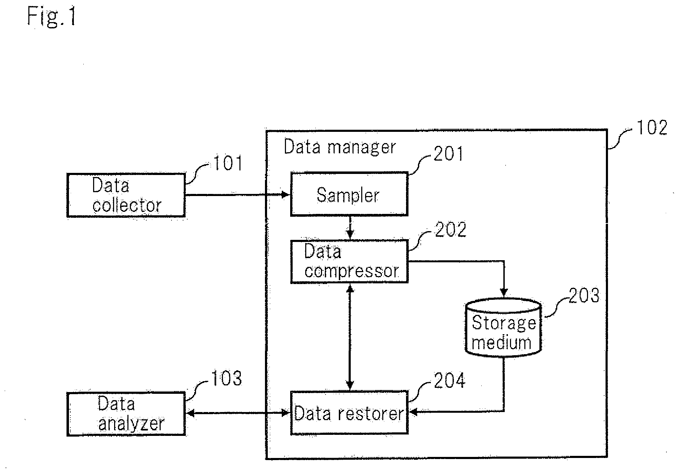

The configuration of an exemplary embodiment will be described with reference to FIG. 1.

Referring to FIG. 1, the data storage apparatus of this exemplary embodiment includes data collector 101 that collects data on resources of a computer system at regular intervals, data manager 102 that samples and stores the resource data collected by data collector 101 at regular intervals and restores the stored resource data, and data analyzer 103 that analyzes the resource data restored by data manager 102 and predicts changes in the resources of the computer system and resource anomalies that can occur in the future.

Data manager 102 includes sampler 201 that samples resource data collected by data collector 101 at regular intervals, data compressor 202 that compresses resource data, storage medium 203 that stores the resource data compressed by data compressor 202, and data restorer 204 that restores resource data stored in storage medium 203.

(2) Operations of the Exemplary Embodiment

Operations of the present exemplary embodiment will be described below.

(2-1) Data Storing Operation

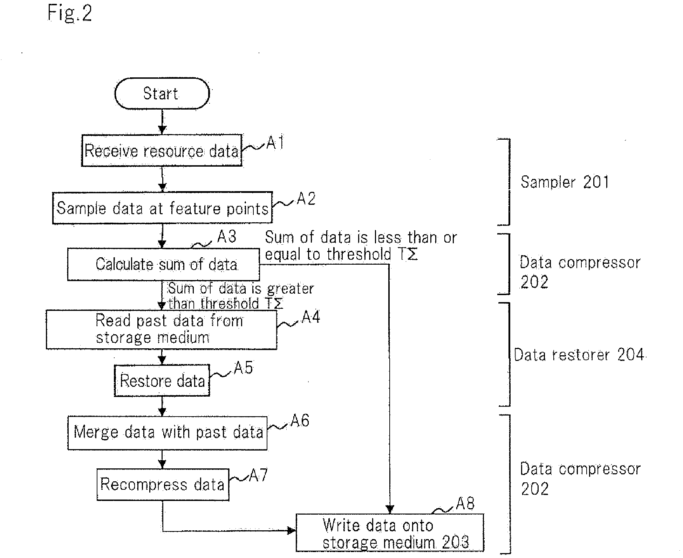

An operation of storing resource data on storage medium 203 will be described first with reference to FIG. 2.

Referring to FIG. 2, data collector 101 collects resource data at regular intervals and sends the collected resource data to data manager 102 at regular time intervals (for example once every hour).

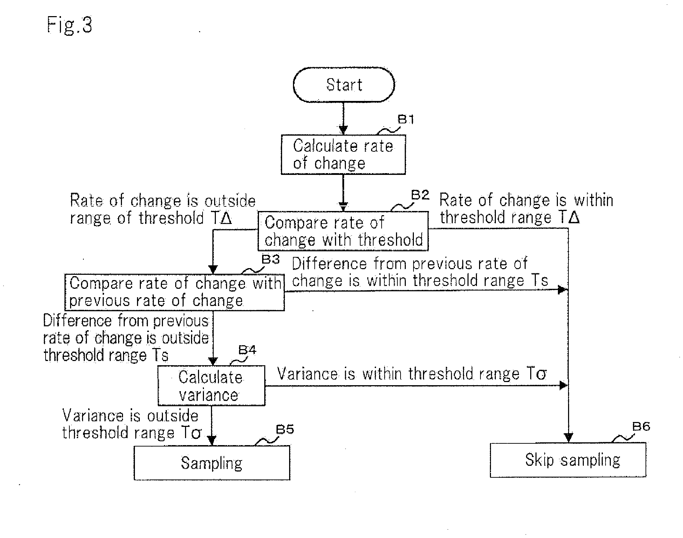

When sampler 201 receives the resource data from data collector 101 at step A1, sampler 201 samples resource data at feature points in the received resource data at step A2 according to a dynamic sampling procedure illustrated in FIG. 3.

The procedure (dynamic sampling procedure) at step A2 of FIG. 2 will be described here in detail with reference to FIG. 3.

Referring to FIG. 3, sampler 201 performs calculation on observation values (resource data) at observation points received from data collector 101 one after another. At step B1, sampler 201 calculates the rate of change $\Delta tx$ at the current observation point tx. The rate of change $\Delta tx$ is calculated as the gradient of the observation values at the current observation point tx and the next observation point tx+1 as:

$$\Delta tx = f(tx + 1) - f(tx)/(tx+1 - tx)$$

Here, f(z) represents the observation value at observation point z.

Sampler 201 then compares $\Delta tx$ with a predetermined threshold T$\Delta$ (for example the range of -1 to 1) at step B2.

If $\Delta tx$ is within the threshold range T$\Delta$ at step B2, sampler 201 proceeds to step B6 and skips sampling of observation value f(tx) at observation point f(tx).

On the other hand, if $\Delta tx$ is outside the threshold range $\Delta$**T** at step B2, sampler 201 proceeds to step B3.

Then sampler 201 compares $\Delta tx$ with the rate of change $\Delta tx$-1 at the previous observation point tx-1 at step B3.

If the difference between $\Delta tx$ and $\Delta tx$-1 is within a predetermined threshold range Ts at step B3, sampler 201 proceeds to step B6 and skips sampling of observation value f(tx) at observation point tx.

On the other hand, if the difference ($\Delta tx$ - $\Delta tx$-1) between $\Delta tx$ and $\Delta tx$- is outside the threshold range Ts at step B3, sampler 201 proceeds to step B4.

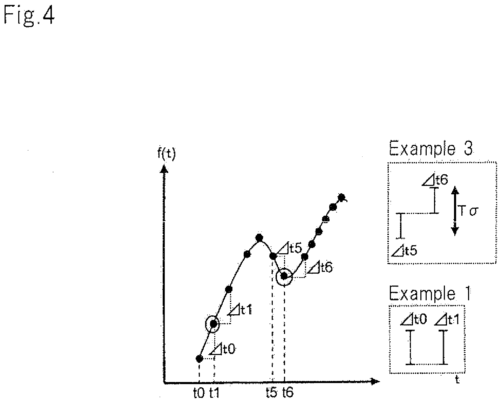

Assume, for example, that the rate of change $\Delta t1$ at observation point t1 in example 1 in Fig. 4 is outside the threshold range T$\Delta$ but the difference between the rate of change $\Delta t1$ and the previous rate of change $\Delta t0$ is within the threshold range Ts. In this case, sampler 201 determines that changes t0 and t1 are equal and that t1 is not a feature point, and skips sampling of observation value f(t1) at t1.

At step B4, sampler 201 then calculates the degree of dispersion among a predetermined number (for example 10) of observation values in the vicinity of observation point tx as a variance $\sigma tx$.

If $\sigma tx$ is within a predetermined threshold range T$\sigma$ at step B4, sampler 201 proceeds to step B6 and skips sampling of observation value f(tx) at observation point tx.

On the other hand, if $\sigma tx$ is outside the threshold range T$\sigma$ at step B4, sampler 201 determines that observation point tx is a feature point and samples observation value f(t1) at t1 at step B5.

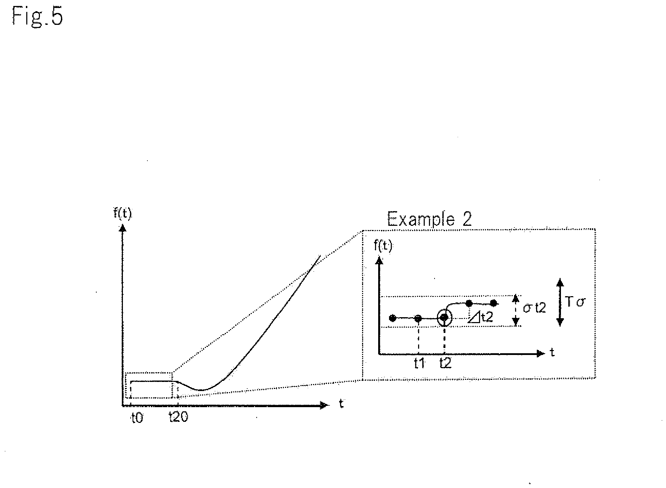

Assume, for example, that the rate of change $\Delta 2$ at observation point t2 in example 2 in FIG. 5 is outside the threshold range T$\Delta$ and the difference between the rate of change $\Delta t2$ and the previous rate of change $\Delta t1$ is also out of the threshold range Ts, but the variance $\sigma t2$ is within the threshold range T$\sigma$. In this case, the rate of change at t2 is large and the change at t2 is not equal to the previous change. However, looking at the entire resource data, the absolute amount of the change is small. Accordingly, the change at t2 can be considered to be too small to represent a feature of the resource data. Therefore, sampler 201 determines that t2 is not a feature point and skips sampling of the observation value f(t2) at t2.

Assume, for example, the rate of change $\Delta t6$ at observation point t6 in example 3 in FIG. 4 is outside the threshold range T$\Delta$, the difference between rate of change $\Delta t6$ and previous rate of change $\Delta t5$ is outside the threshold range Ts, and the variance $\sigma t6$ is also outside the threshold range T$\sigma$. In this case, the rate of change at t6 is large, the change at t6 is not equal to the previous change and the absolute amount of the change is large in the whole resource data. Accordingly, t6 can be considered to be the start point of change. Therefore, sampler 201 determines that t6 is a feature point and samples the observation value f(t6) at t6.

Returning to FIG. 2, at step A3, data compressor 202 calculates the sum of the number of pieces of resource data sampled by sampler 201 and the number of pieces of the past resource data stored on storage medium 203.

If the sum of the number of pieces of the resource data is less than or equal to a predetermined threshold TΣ at step A3, data compressor 202 compresses the resource data extracted by sampler 201 and stores the compressed resource data onto storage medium 203 in append mode at step A8.

On the other hand, if the sum of the number of pieces of the resource data is greater than the threshold TΣ at step A3, data compressor 202 requests data restorer 204 to restore all of the past resource data stored on storage medium 203.

In response to the request, data restorer 204 reads all of the past resource data stored on storage medium 203 at step A4 and restores all the read resource data at step A5.

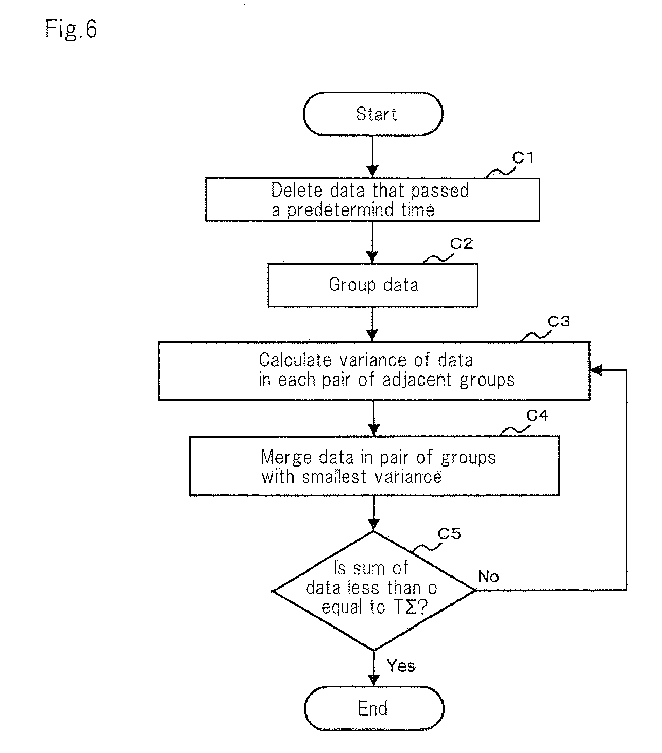

Then at step A6, data compressor 202 follows a data merge procedure in FIG. 6 to merge (combine) adjacent pieces of data in a set of resource data including the resource data sampled by sampler 201 and the resource data restored by data restorer 204 by using a statistical index until the sum of the pieces of resource data to be stored on storage medium 203 decreases to a value less than or equal to the threshold TΣ.

Data compressor 202 then recompresses the merged resource data and stores the recompressed resource data onto storage medium 203 in overwrite mode at step A7.

The procedure at step A6 of FIG. 2 (the data merge procedure) will be described here in detail with reference to FIG. 6.

Referring to FIG. 6, data compressor 202 first deletes resource data that passed a predetermined retention time period among the resource data restored by data restorer 204 at step C1. The range of resource data to be deleted can be set arbitrarily.

When data analyzer 103 predicts changes in resources and abnormalities in resources that can occur in the future as in this exemplary embodiment, for example, the influence of the past resource data on the prediction may be not so large. For example, 2-year-old resource data has an insignificant influence on predicting a change in resources on the next day. Therefore, deletion described above is performed.

Data compressor 202 then groups the resource data sampled by sampler 201 and the resource data restored by data restorer 204 together at step C2.

The resource data restored by data restorer 204 includes resource data (first data) at feature points and resource data (second data) at non-feature points calculated based on the feature points, which will be detailed later.

Data compressor 202 groups a set of resource data represented by one feature point (that is, a set of data made up of resource data at a feature point and resource data at a non-feature point calculated based on the feature point) as one group. Accordingly, at this time point, the resource data sampled by sampler 201 constitutes one group by itself.

At step C3, data compressor 202 then calculates, for each pair of adjacent groups, a statistical index of the resource data in the two groups. Here, the statistical index is a variance (the degree of dispersion) of the resource data in the two groups.

At step C4, data compressor 202 then selects a pair that has the smallest variance among the pairs of groups and merges the resource data in the selected two groups. The two groups in which the resource data are merged together will subsequently be treated as one group.

Data compressor 202 repeats steps C3 to C4 until the sum of the number of pieces of resource data stored on storage medium 203 is less than or equal to the threshold TE at step C5.

(2-2) Date Restore Operation

An operation for restoring resource data stored on storage medium 203 will be described below.

When a need for restoring resource data arises, data analyzer 103 and data compressor 202 issue a restore request to data restorer 204. In the restore request, the data range of resource data to be restored and the data interval (such as X seconds or X hours) are specified.

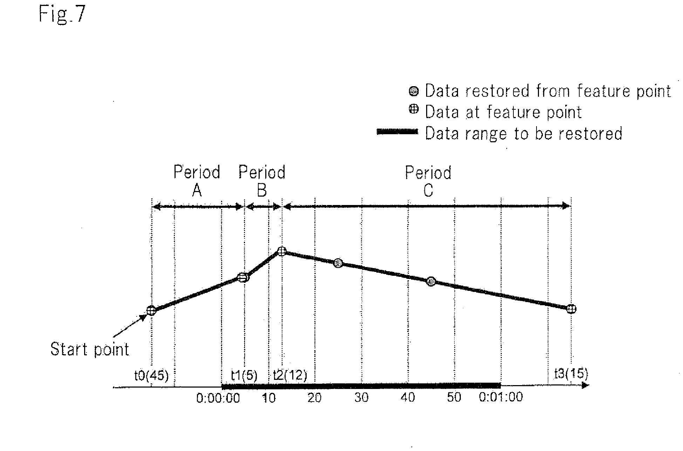

The procedure performed by data restorer 204 to restore resource data will be described here in detail with reference to FIG. 7. It is assumed in FIG. 7 that a data range of 0:00 to 0:01 and a data interval of 20 seconds are specified in the restore request.

Referring to FIG. 7, data restorer 204 first reads and restores feature points in the specified data range 0:00 to 0:01, one feature point before the specified data range and one feature point after the specified data range. Here, data restorer 204 reads and restores the feature points at time t1 (0:00:05) and time t2 (0:00:12) within the specified data range, the feature point at time t0 (23:59:45) before the specified data range, and the feature point at time t3 (0:01:15) after the specified data range.

Data restorer 204 then derives a linear equation, $y = ax + b$, that represents the resource data in period A between a start point, which is the feature point at time t0, and time t1 at which the next feature point exists using the feature points at time t0 and at time t1. Data restorer 204 uses the derived linear expression to restore resource data at the specified data intervals in period A from the start point. Here, the resource data at time t1 (0:00:05) is restored.

Similarly, data restorer 204 then derives a linear expression y = ax + b for period B between time t1 and time t2 at which the next feature point exists. However, the time 0:00:25 at which resource data is to be restored next is outside period B. Accordingly, data restorer 204 does not restore resource data in period B.

Data restorer 204 then similarly derives a linear equation y = ax + b for period C between time t2 and time t3 at which the next feature point exists. Here, the time 0:00:25 at which resource data is to be restored next and the time 0:00:45 at which resource data is to be restored after that are within period C. Therefore, the linear equation derived above is used to restore resource data at time 0:00:25 and time 0:0045.

Here, time 0:01:05 after the specified data interval has elapsed from time 0:00:45 is outside the specified data range. Therefore the resource data restoration ends here.

Data restorer 204 sends the resource data restored as described above to data analyzer 103 or to data compressor 202. Before sending the resource data, data restorer 204 adds an identifier to each piece of the resource data, indicating whether the piece of resource data is data at a feature point or data at a non-feature point calculated on the basis of a feature point. While the resource data at time t1 (0:00:05) in FIG. 7 is non-feature point resource data as well as feature point resource data, the resource data is sent as feature-point resource data.

When data analyzer 103 receives the resource data restored by data restorer 204, data analyzer 103 statistically analyzes the resource data to predict changes in the resources and predict resource anomalies that can occur in the future.

When data compressor 202 receives the resource data restored by data restorer 204, data compressor 202 merges and recompresses the resource data by following the data merge procedure described above.

As has been described above, a plurality of change indices are calculated for each piece of time-series data and, based on the calculated change indices, determination is made as to whether or not the data is to be sampled.

Thus, the number of pieces of data sampled can be satisfactorily reduced while improving the accuracy of the sampling.

For example, when time-series data changes linearly, the time-series data can be reproduced by previously sampling only the data at the start and end points of the change.

If only the amount of change is used as the change index as in JP10-143543A, there is the potential of sampling the data in the entire period during which the data is linearly changing, depending on the gradient of the time-series data.

According to the present exemplary embodiment, a plurality of change indices, for example, the rate of change and the difference between rates of change, are used and, when the rate of change at a given observation point is outside a threshold value but there is no difference between that rate of change and the previous rate of change, it is determined that the observation point is not a feature point and sampling is not performed.

Thus, the accuracy of sampling can be improved by using a plurality of change indices according to the present exemplary embodiment and, consequently, the number of pieces of data sampled can be satisfactorily reduced.

Furthermore, according to the present exemplary embodiment, when the sum of the number of pieces of data stored on the storage medium exceeds the threshold, adjacent pieces of data in sampled data and data restored from the storage medium are merged together by using a statistical index until the sum of data stored on the storage medium decreases to a value less than or equal to the threshold.

Accordingly, the number of pieces of data stored on the storage medium can be kept at a certain low level.

(3) Other Exemplary Embodiments

Having described the present invention with reference to an exemplary embodiment, it should be understood that the present invention is not limited to the exemplary embodiment described above. Various modifications that would be apparent to those skilled in the art can be made to the configurations and details of the present invention without departing form the scope of the present invention.

Indices for dynamic sampling and merge

While the rate of change, the difference between rates of change, and the variance are used as the change indices for determining whether to take a sample, the present invention is not limited to these change indices; other change indices such as an inflection point and variance or a differential and a quartile value, can be used.

Furthermore, while the variance of the data in two groups is used as a statistical index for determining two groups to merge data in the exemplary embodiment described above, the present invention is not limited to this; other statistical index such as the degree of similarity of the correlation coefficients of data in two groups can be used.

Prioritizing merge and accuracy of data

In the exemplary embodiment described above, when the number of pieces of data stored on the storage medium exceeds the threshold $T\Sigma$, data are unconditionally merged until the number of pieces of data stored on the storage medium decreases to a value less than or equal to $T\Sigma$ in order to keep the number of pieces data stored on the storage medium at a certain low level.

However, in the case of time-series data that radically changes, merging can lower the accuracy of the time-series data.

To address this, a limit can be placed on the value of statistical index (for example variance) used for determining groups of data to be merged. When the limit is exceeded (for example when the variance exceeds the threshold), merge can be avoided to give priority to the accuracy of the time-series data.

The present invention can be applied to storage of resource data in the field of monitoring resources of computer systems.

## Claims

1. A data storage apparatus comprising:

   a data collector that collects time-series data; and
   a sampler that calculates a plurality of change indices indicating a change in each piece of the data and determines, on the basis of the result of the calculation, whether or not the piece of the data is to be sampled.

2. The data storage apparatus according to claim 1, wherein said sampler performs calculation on the data one after another to calculate as the change indices of a current piece of the data on which the calculation is performed, the rates of change of the current piece of data and a next piece of data, a difference between the rate of change of the current piece of data and the rate of change of a previous piece of data, and a variance of a predetermined number of pieces of data in the vicinity of the current piece of data.

3. The data storage apparatus according to claim 2, wherein said sampler determines that the current piece of data is to be sampled when the ratio of change of the current piece of data is outside a predetermined range, the difference between the rate of change of the current piece of data and the rate of change of the previous piece of data is outside a predetermined range, and the variance of the current piece of data is outside a predetermined range.

4. The data storage apparatus according to any one of claims 1 to 3, further comprising:

   a data compressor that compresses the data and stores the compressed data on a storage medium; and
   a data restorer that restores data stored on the storage medium;

   wherein when the sum of the number of pieces of data sampled by said sampler and the number of pieces of data stored on the storage medium is greater than a predetermined threshold, said data compressor causes said data restorer to restore data stored on the storage medium, merges adjacent pieces of data in a set of data including the sampled data and the restored data together by using a statistical index until the sum of the number of pieces of data stored on the storage medium decreases to a value less than or equal to the threshold, and recompresses the merged data and stores the recompressed data on the storage medium.

5. The data storage apparatus according to claim 4, wherein:

   said data restorer restores data stored on the storage medium as first data and restores second data obtained by calculation based on the first data; and
   said data compressor groups the set of data so that the first data and the second data obtained by the calculation based on the first data are grouped into one group, and repeats, for each pair of adjacent two groups, a first operation of calculating a variance of data in the two groups as the statistical index and a second operation of selecting a pair that has the smallest variance from among the pairs of adjacent two groups and merging the data in the selected pair of groups until the sum of the number of pieces of data stored on the storage medium decreases to a value less than or equal to the threshold.

6. A data storage method performed by a data storage apparatus comprising:

   collecting time-series data; and
   sampling the time series data by calculating a plurality of change indices indicating a change in each piece of the data and determining, on the basis of the result of the calculation, whether or not the piece of the data is to be sampled.

7. The data storage method according to claim 6, wherein said sampling performs calculation on the data one after another to calculate as the change indices of a current piece of the data on which the calculation is performed, the rates of change of the current piece of data and a next piece of data, a difference between the rate of change of the current piece of data and the rate of change of a previous piece of data, and a variance of a predetermined number of pieces of data in the vicinity of the current piece of data.

8. The data storage method according to claim 7, wherein said sampling determines that the current piece of data is to be sampled when the ratio of change of the current piece of data is outside a predetermined range, the difference between the rate of change of the current piece of data and the rate of change of the previous piece of data is outside a predetermined range, and the variance of the current piece of data is outside a predetermined range.

9.  The data storage method according to any one of claims 6 to 8, further comprising:

    when the sum of the number of pieces of data sampled and the number of pieces of data stored on the storage medium is greater than a predetermined threshold, restoring data stored on the storage medium; merging adjacent pieces of data in a set of data including the sampled data and the restored data together by using a statistical index until the sum of the number of pieces of data stored on the storage medium decreases to a value less than or equal to the threshold; and recompressing the merged data and storing the recompressed data on the storage medium.

10. The data storage method according to claim 9, wherein:

    said restoring restores data stored on the storage medium as first data and restores second data obtained by calculation based on the first data; and said merging groups the set of data so that the first data and the second data obtained by the calculation based on the first data are grouped into one group, and repeats, for each pair of adjacent two groups, a first operation of calculating a variance of data in the two groups as the statistical index and a second operation of selecting a pair that has the smallest variance from among the pairs of adjacent two groups and merging the data in the selected pair of groups until the sum of the number of pieces of data stored on the storage medium decreases to a value less than or equal to the threshold.

Fig.1

Fig.2

```
                    ┌──────────────┐
                    (    Start      )
                    └──────┬───────┘
                           ▼
              ┌───────────────────────┐
              │ Receive resource data │──A1        ┐
              └───────────┬───────────┘             │
                          ▼                          ├ Sampler 201
           ┌──────────────────────────┐             │
           │ Sample data at feature points │──A2    ┘
           └──────────────┬───────────┘
                          ▼    ~A3       Sum of data is less than or
           ┌──────────────────────┐     equal to threshold TΣ       ┐
           │  Calculate sum of data │─────────────────────┐         ├ Data compressor
           └──────────────┬───────┘                       │         │  202
              Sum of data is greater                       │         ┘
                than threshold TΣ                          │
           ┌──────────────────────┐                        │        ┐
           │  Read past data from  │──A4                    │        │
           │  storage medium       │                        │        │
           └──────────┬───────────┘                         │        ├ Data restorer 204
              ┌────────────────┐                            │        │
              │  Restore data   │──A5                        │        │
              └────────┬───────┘                             │        ┘
                       ▼
           ┌──────────────────────┐                         │
           │ Merge data with past data │──A6                │
           └──────────┬───────────┘                         │        ┐
                      ▼                                      │        │
           ┌────────────────┐                               │        │
           │ Recompress data │──A7                          │        │
           └────────┬───────┘                               │        ├ Data compressor
                    │                                        │        │  202
                    │                       ~A8              │        │
                    │        ┌──────────────────────┐       │        │
                    └───────►│  Write data onto      │◄──────┘        │
                             │  storage medium 203   │                ┘
                             └──────────────────────┘
```

Fig.3

Fig.4

Fig.5

Example 2

Fig.6

```
                    ┌──────────┐
                    │  Start   │
                    └────┬─────┘
                         │              C1
              ┌──────────▼──────────────┐
              │  Delete data that passed │
              │  a predetermind time     │
              └──────────┬──────────────┘
                         │              C2
                 ┌───────▼────────┐
                 │  Group data    │
                 └───────┬────────┘
                         │              C3
         ┌───────────────▼─────────────────┐◄──┐
         │  Calculate variance of data      │   │
         │  in each pair of adjacent groups │   │
         └───────────────┬─────────────────┘   │
                         │              C4      │
          ┌──────────────▼──────────────┐      │
          │  Merge data in pair of groups│      │
          │  with smallest variance      │      │
          └──────────────┬──────────────┘      │
                         │              C5      │
                    ◇────▼────◇   No            │
                   ╱ Is sum of  ╲───────────────┘
                  ⟨ data less than o⟩
                   ╲ equal to TΣ? ╱
                    ◇────┬────◇
                         │ Yes
                    ┌────▼─────┐
                    │  End     │
                    └──────────┘
```

Fig.7

Data restored from feature point
Data at feature point
Data range to be restored

Period
A
Period
B
Period
C

Start point

t0(45)
t1(5)
t2(12)
t3(15)

0:00:00    10    20    30    40    50    0:01:00

EP 2 500 835 A1

Europäisches Patentamt
European Patent Office
Office européen des brevets

**EUROPEAN SEARCH REPORT**

Application Number

EP 12 15 6157

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "1: Measurement and Sampling", internet article, 2003, XP002679666, Retrieved from the Internet: URL:http://www.sjsu.edu/faculty/gerstman/StatPrimer/Measure.PDF [retrieved on 2012-07-11] * the whole document * * page 1.5 * | 1-10 | INV. G06F17/40 H03M7/30 |

|  |  |  | TECHNICAL FIELDS SEARCHED (IPC) |
|---|---|---|---|
|  |  |  | G06F H03M |

The present search report has been drawn up for all claims

| Place of search | Date of completion of the search | Examiner |
|---|---|---|
| The Hague | 11 July 2012 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011060597 A
- JP 10143543 A
- JP 101435543 A